# EUROPÄISCHE PATENTSCHRIFT

(11) **EP 2 681 575 B1**
(45) Veröffentlichungstag und Bekanntmachung des Hinweises auf die Patenterteilung: **19.11.2014**
(21) Anmeldenummer: 12710163.2
(22) Anmeldetag: 22.02.2012
(51) Int. Cl.: G01R 33/3815, F25B 23/00, H02K 55/04

(54) **KÜHLEINRICHTUNG ZUR KÜHLUNG EINES SUPRALEITERS, INSBESONDERE IN EINER MAGNETRESONANZEINRICHTUNG ODER EINEM ROTOR**
COOLING DEVICE FOR COOLING A SUPERCONDUCTOR, IN PARTICULAR IN A MAGNETIC RESONANCE DEVICE OR A ROTOR
DISPOSITIF DE REFROIDISSEMENT DESTINÉ À REFROIDIR UN SUPRACONDUCTEUR, EN PARTICULIER DANS UN DISPOSITIF DE RÉSONANCE MAGNÉTIQUE OU UN ROTOR

(30) Priorität: 02.03.2011 DE 102011004952
(43) Veröffentlichungstag der Anmeldung: 08.01.2014
(73) Patentinhaber: Siemens Aktiengesellschaft, 80333 München (DE)
(72) Erfinder: FRANK, Michael, 91080 Uttenreuth (DE); KUMMETH, Peter, 91074 Herzogenaurach (DE); SCHMIDT, Heinz, 91096 Möhrendorf (DE); VAN HASSELT, Peter, 91058 Erlangen (DE)
(86) Internationale Anmeldenummer: PCT/EP2012/052968
(87) Internationale Veröffentlichungsnummer: WO 2012/116911

(56) Entgegenhaltungen:
- WO-A2-2012/095330
- GB-A- 2 225 099
- US-A1- 2010 248 968
- NICK W ET AL: "380 kW synchronous machine with HTS rotor windings--development at Siemens and first test results", PHYSICA C, NORTH-HOLLAND PUBLISHING, AMSTERDAM, NL, Bd. 372-376, 1. August 2002 (2002-08-01), Seiten 1506-1512, XP004375716, ISSN: 0921-4534, DOI: 10.1016/S0921-4534(02)01069-9

## Beschreibung

Die Erfindung betrifft ein Verfahren zur Kühlung eines Supraleiters, insbesondere in einer Magnetresonanzeinrichtung und/oder einem Rotor einer supraleitenden Maschine, wobei der Supraleiter und/oder ein den Supraleiter tragendes Bauteil in Kontakt mit einem flüssigen Kühlmedium bringbar ist, sowie eine Magnetresonanzeinrichtung und eine supraleitende Maschine mit einer solchen Kühleinrichtung.

Supraleiter, insbesondere die sogenannten Hochtemperatur-Supraleiter, deren Sprungtemperatur oberhalb von 77 K liegt, werden immer häufiger in verschiedensten Anwendungen benutzt. Beispielsweise ist es bekannt, supraleitende Wicklungen, meist aus Niedrigtemperatur-Supraleitern, in Magnetresonanz-Magneten, und, insbesondere Hochtemperatur-Supraleiter, in Maschinen, also Generatoren und/oder Motoren, einzusetzen. Dabei ist es notwendig, die im jeweiligen Fall maximal zulässige Betriebstemperatur des Supraleiters strikt einzuhalten. Hierzu sind verschiedene Kühleinrichtungen bekannt, die als Kühlmedium kryogene Flüssigkeiten, beispielsweise Helium, Wasserstoff, Neon oder Stickstoff, einsetzen, die beim Verdampfen die erforderliche Kälteleistung bereitstellen. Die Rückführung des verdampften Kühlmediums erfolgt entweder periodisch durch Nachfüllen oder durch Kondensation in einem Kondensorraum an einem oder mehreren Kaltköpfen in einem insbesondere geschlossenen Kühlmittelkreislauf.

Dabei kann sich das Problem ergeben, dass eine Zuführung des Kühlmediums zu dem Supraleiter auf "kurzem Weg" teilweise nicht unmittelbar realisierbar ist. So sind beispielsweise Magnetresonanz-Einrichtungen bekannt, in denen die supraleitende Magnetresonanz-Wicklung in einem Bad aus flüssigem Kühlmedium, insbesondere flüssigem Helium, (sogenannte Bad-Kühlung des Supraleiters) gehalten wird. Dabei sinkt der Pegel des flüssigen Kühlmediums im Lauf der Zeit durch Verdampfung beträchtlich ab, so dass vor dem Nachfüllen der obere Teil der supraleitenden Wicklung freigelegt ist, das bedeutet, nur von Gas umgeben ist. Dieser freiliegende Teil der supraleitenden Wicklung wird dann nur durch Wärmeleitung aus dem im flüssigen Kühlmedium befindlichen, gekühlten Teil der Wicklung gekühlt und kann demzufolge eine höhere Temperatur aufweisen, die die effektive Ausnutzung des Supraleiters begrenzt, beispielsweise im Hinblick auf den erlaubten Betriebsstrom.

Zur Kühlung von supraleitenden Maschinen, bei denen beispielsweise eine supraleitende Rotorwicklung an einem Wicklungsträger innerhalb des Rotors befestigt sein kann, werden meist geschlossene Kühlkreisläufe verwendet, bei denen in einem geschlossenen System beispielsweise Neongas oder Stickstoff als Kühlmedium an einem Kaltkopf mit Kondensor verflüssigt werden. Von dort aus fließt das Kühlmedium in einen hohlen Innenraum des Rotors, wo es den thermisch leitfähigen Wicklungsträger kontaktiert und dort verdampft, um seine Kühlwirkung zu erzielen. Das bedeutet, der Innenraum des Rotors wirkt als ein Verdampfer. Das verdampfte Kühlmedium gelangt zurück zum Kondensor und wird dort erneut verflüssigt. Hierbei wird der sogenannte Thermosiphon-Effekt ausgenutzt. Das flüssige Kühlmedium verdampft an dem Wicklungsträger und strömt gasförmig aufgrund des Druckunterschieds, der aufgrund des Verdampfens im Verdampfer und des Kondensierens im Kondensorraum des Kondensors entsteht, zum Kondensor zurück. Solche Kältemittelströmungen werden häufig auch als "heat pipe" bezeichnet.

Der Transport des flüssigen Kühlmediums zu dem Supraleiter wird bei den bekannten Kühleinrichtungen durch die Schwerkraft bewerkstelligt, das bedeutet, der Kondensor ist geodätisch höher als der Verdampfer angeordnet. Diese Vorgehensweise erweist sich immer dann als schwierig, wenn eine Schräglage der Kühleinrichtung bzw. der supraleitenden Synchronmaschine auftreten kann, wie es beispielsweise bei supraleitenden Synchronmaschinen für Schiffsanwendungen, also beispielsweise HTS-Motoren oder HTS-Generatoren, möglich ist. Bei Seefahrzeugen wie Schiffen kann es leicht zu einer Schräglage bzw. Neigung des Schiffes kommen. Neben statischen Schieflagen, die "Trim" genannt werden, sind auch dynamische Schieflagen möglichen. Dann kann das flüssige Kühlmedium gegebenenfalls nicht in den Verdampfer gelangen und seine Kühlwirkung entfalten.

Hierdurch ergeben sich hauptsächlich Designbeschränkungen, insbesondere in Anwendungsfeldern, in denen eine Raumknappheit vorliegt, die es nicht erlaubt, einen geodätisch höherliegenden Kondensor mit einem Kaltkopf, der üblicherweise mit einem Kompressor verbunden ist, vorzusehen. Dies gilt neben Seefahrzeugen oder Seeplattformen auch bei anderen Vorrichtungen, die einer Höhenbeschränkung unterworfen sind, beispielsweise einem Triebwagen einer Eisenbahn oder dergleichen.

Grundsätzlich ist es denkbar, kryogene Umwälzpumpen oder Förderpumpen zu verwenden. Derartige Pumpen weisen jedoch eine große Zahl an Nachteilen auf. Sie haben eine geringe Lebensdauer und sind sehr störanfällig, zudem ist die Wartung/Reparatur ohne Betriebsunterbrechung extrem schwierig. Komplexe bewegte Bauteile bei kryogenen Temperaturen verlässlich zu realisieren, ist zudem äußerst aufwendig. Eine solche Pumpe bedingt weiterhin eine Wärmeeinleitung und senkt den Wirkungsgrad einer supraleitenden Maschine, so dass eine derartige Lösung in der Praxis vermieden werden soll.

Verfahren zur Kühlung eines Supraleiters, in denen der Supraleiter in Kontakt mit einem flüssigen Kühlmittel gebracht wird, sind z.B. aus der GB-A-2 467 596 und dem Artikel "380 kW synchronous machine with HTS rotor windings - development at Siemens and first test results", Nick W. et al, Physica C, 372-376 (2002) 1506-1512 bekannt, wobei in dem Artikel die Kühlung von Rotorwicklungen mit Heliumgas beschrieben wird und in der Patentanmeldung die Kühlung eines Supraleiters für ein MRT-System.

Der Erfindung liegt daher die Aufgabe zugrunde, eine Kühleinrichtung anzugeben, die ohne die Nachteile einer elektrisch zu betreibenden Pumpe eine Förderung und/oder ein Umwälzen gegen die Schwerkraft erlaubt. Zur Lösung dieser Aufgabe ist bei dem erfindungsgemässen Verfahren gemäss Anspruch 1 vorgesehen, dass zur Förderung des Kühlmediums zu dem Supraleiter und/oder zur Umwälzung des Kühlmediums in einem Bad für den Supraleiter eine in einer Förderleitung angeordnete Blasenpumpe verwendet wird. Details des Verfahrens sind Anspruch 1 zu entnehmen. Vorteilhafte Ausführungsformen sind in den Ansprüchen 2-7 definiert. Die Ansprüche 8 und 9 spezifieren eine Magnetresonanzeinrichtung bzw. eine supraleitende, einen Rotor umfassende Maschine, welche jeweils eine zur Durchführung des erfindungsgemässen Verfahrens ausgebildete Kühleinrichtung umfassen.

Erfindungsgemäß wird also vorgeschlagen, eine Blasenpumpe, deren Funktionsprinzip beispielsweise von Kaffeemaschinen her bekannt ist, besonders vorteilhaft in einer kryogenen Umgebung einzusetzen, um flüssiges Kühlmedium durch gezielte Verdampfung eines kleinen Teils des Kühlmediums, zu erlauben, welcher beim Aufsteigen flüssiges Kühlmedium periodisch oder quasi kontinuierlich nach oben fördert. Es soll also das Prinzip einer Blasenpumpe auf supraleitende Anwendungen bei kryogenen Arbeitstemperaturen angewandt werden. Auf diese Weise sind keine hochkomplexen Umwälzpumpen oder Förderpumpen mehr erforderlich, nachdem sich eine Blasenpumpe mit einem sehr geringen Aufwand, insbesondere einem sehr geringen Leistungseintrag, realisieren lässt. Auf eine elegante Art und Weise kann das flüssige Kühlmedium gegen die Schwerkraft gefördert werden, so dass es insbesondere auch ermöglicht werden kann, einen Kondensor bzw. den Kondensorraum des Kondensors geodätisch niedriger als den zu kühlenden Supraleiter, letztlich also den Verdampfer, anzuordnen.

Die Blasenpumpe umfasst dabei eine Heizung zur definierten Erzeugung von das verflüssigte Kühlmedium gegen die Schwerkraft fördernden Blasen des gasförmigen Kühlmediums. Es wird also eine Heizung an die Förderleitung angekoppelt, die genau so betrieben wird, dass eine den Querschnitt der Förderleitung ausfüllende, durch den Auftrieb flüssiges Kühlmedium tragende Blase erzeugt wird, die dann gegen die Schwerkraft in der Förderleitung aufsteigt und dabei flüssiges Kühlmedium mit sich bringt. Die Heizung kann beispielsweise periodisch betrieben werden, um durch Einbringen einer definierten Heizleistung eine definierte, auf die Förderleitung abgestimmte Blasengröße zu erzeugen. Dabei sind äußerst geringe Heizleistungen bereits vollkommen ausreichend, so dass die Blasenpumpe aufwandsarm realisiert werden kann und den Wirkungsgrad der Kühleinrichtung bzw. der ihr zugeordneten Anwendung kaum absenkt. Insbesondere ist keine mechanische Förderung wie bei Umwälzpumpen oder Förderpumpen notwendig, so dass in Kontakt mit dem flüssigen Kühlmedium stehende Förderteile vollkommen vermieden werden können. Es ist also auch eine mechanische Einfachheit gegeben. Zweckmäßigerweise kann die Heizung, falls sie sich im Bad für den Supraleiter befindet, eine Isoliervorrichtung umfassen, die zur thermischen Isolation der Heizung gegen das im Bad vorgehaltene flüssige Kühlmedium ausgebildet ist. Beispielsweise kann ein Vakuumgefäß oder dergleichen um die Heizung gelegt werden. Als Heizung kann beispielsweise ein elektrisches Heizmittel eingesetzt werden.

Ferner kann vorgesehen sein, dass die Förderleitung wenigstens im Bereich der Förderung durch die Blasenpumpe vertikal verläuft. Bei einer vertikal verlaufenden Förderleitung wird das Maximum des Auftriebs der erzeugten Blasen ausgenutzt, so dass idealerweise ein senkrecht nach oben gerichteter Förderabschnitt vorgesehen wird.

In besonders vorteilhafter Ausgestaltung der vorliegenden Erfindung kann vorgesehen sein, dass der Blasenpumpe in Förderrichtung ein Rückschlagventil vorgeschaltet ist. Es hat sich gezeigt, dass die Verwendung eines derartigen, insbesondere ansteuerungsfreien Rückschlagventils nochmals deutlich zur Steigerung des Wirkungsgrades beiträgt, nachdem der Rückfluss von Kühlmedium in das Bad oder in einen Kondensorraum effektiv verhindert wird.

In einer konkreten Ausgestaltung der vorliegenden Erfindung kann vorgesehen sein, dass der zu kühlende Supraleiter ein Supraleiter einer supraleitenden Magnetresonanz-Wicklung ist und dass die Blasenpumpe ein nicht die gesamte Wicklung in einem Verdampfungsraum aufnehmendes flüssiges Kühlmedium durch die Blasenpumpe zu dem freiliegenden Teil der Wicklung, insbesondere auf eine obere Oberfläche der Wicklung, fördert. Dabei kann insbesondere eine Anordnung vorgesehen werden, bei der eine Fördereinrichtung verwendet wird, die in das flüssige Kühlmedium des Bades, insbesondere nahe bis zum Boden des Verdampfungsraums, reicht, wobei insbesondere auch die Heizung der Blasenpumpe innerhalb des flüssigen Kühlmedium-Bades angeordnet ist. Von dort aus kann durch die Förderleitung flüssiges Kühlmedium noch oben, also aus dem Bad heraus, bis zu einer oberhalb der supraleitenden Wicklung reichenden Austrittsöffnung der Fördereinrichtung geführt werden, von wo es auf den freiliegenden Teil der supraleitenden Wicklung gelangt, beispielsweise tropft. Es sei angemerkt, dass dabei Ausgestaltungen denkbar sind, die nur einen zeitweisen Betrieb der Fördereinrichtung zum Umwälzen des flüssigen Kühlmediums erlauben, beispielsweise dann, wenn wenigstens ein vorbestimmter Teil der supraleitenden Wicklung, beispielsweise zwischen Nachfüllvorgängen, freiliegt. Hierzu kann eine Steuereinrichtung vorgesehen sein, die entweder rein zeitlich die Heizung der Blasenpumpe ansteuert oder anhand von Daten eines Sensors, beispielsweise eines Füllstandsensors, arbeitet. Das bedeutet, solange die supraleitende Wicklung gänzlich in dem Bad eingetaucht ist, ist keine Förderung mit Hilfe der Fördereinrichtung notwendig, sondern erst, wenn ein Teil freiliegt. Andererseits kann die Ausgestaltung der Kühleinrichtung aber auch so gewählt werden, dass beispielsweise die in der Kühleinrichtung insgesamt verwendete Menge an Kühlmedium reduziert ist und grundsätzlich ein Teil freiliegt, der dann über das durch die Blasenpumpe geförderte flüssige Kühlmedium dennoch hinreichend gekühlt wird. Schließlich sei noch angemerkt, dass es selbstverständlich auch möglich ist, mehrere derartige Fördereinrichtungen mit Blasenpumpen in einer derartigen Kühleinrichtung bzw. einer derartigen Magnetresonanzeinrichtung vorzusehen.

Alternativ kann das erfindungsgemäße Verfahren zur Kühlung auch im Rahmen einer supraleitenden Maschine eingesetzt werden, wobei vorgesehen sein kann, dass der zu kühlende Supraleiter ein Supraleiter einer in einem Rotor einer supraleitenden Maschine angeordneten supraleitenden Rotorwicklung ist, wobei das Kühlmedium von einem insbesondere geodätisch niedriger liegenden Kondensorraum durch die Förderleitung in einen als Verdampfungsraum wirkenden Innenraum des Rotors gefördert wird. Mithin ermöglicht es die vorliegende Erfindung im Rahmen supraleitender Maschinen also, das Kühlmedium mit geringem Aufwand auch "bergauf", also gegen die Schwerkraft, zu fördern, was den eingangs genannten Raum- und Anordnungsproblemen entgegenwirkt, nachdem nun der an einen Kaltkopf thermisch angekoppelte Kondensorraum des Kondensors geodätisch niedriger als der eigentlich zu kühlende Supraleiter angeordnet werden kann.

In weiterer Ausgestaltung kann hierbei vorgesehen sein, dass das Kühlmedium in einem geschlossenen Kühlkreislauf geführt wird, wobei das in einem an einen Kaltkopf angekoppelten Kondensorraum verflüssigte Kühlmedium zu dem zu kühlenden Supraleiter in den Innenraum des Rotors gefördert wird und gasförmig zurück in den Kondensorraum geführt wird. Es ist also ein grundsätzlich bekannter geschlossener Kühlkreislauf einsetzbar, in dem die erfindungsgemäß vorgesehene Blasenpumpe zweckmäßig integriert werden kann.

In Weiterbildung der vorliegenden Erfindung kann vorgesehen sein, dass die Förderleitung in ein einen größeren Querschnitt aufweisendes, durch eine Drehdurchführung in den Innenraum des Rotors mündendes Leitungsstück mündet, in dem verflüssigtes Kühlmedium in den Innenraum des Rotors strömen kann, wobei parallel durch ein weiteres Leitungsstück gasförmiges Kühlmedium aus dem Innenraum des Rotors strömen kann. Ein derartiges Leitungsstück hat den Vorteil, dass die zum Transport genutzten Blasen gasförmigen Kühlmediums darin mit genügend Raum in den Innenraum des Rotors mitströmen können, während das flüssige Kühlmittel in den Innenraum des Rotors fließt. Auf diese Weise ist eine äußerst günstige Ausgestaltung gegeben. Insbesondere kann direkt an einem Ende des Leitungsstücks für das gasförmige Kühlmedium, an dem das flüssige Kühlmedium durch die Blasenpumpe zugeführt wird, auch ein weiterer Leitungsabschnitt zum Rücktransport des gasförmigen Kühlmediums zum Kondensor anschließen. Die Verwendung zweier Leitungsstücke vermeidet bei einer Schräglage das Ansaugen flüssigen Kühlmediums in den Kondensorraum.

Neben dem Verfahren zur Kühlung betrifft die vorliegende Erfindung auch eine Magnetresonanzeinrichtung gemäss Anspruch 8, umfassend eine supraleitende Magnetresonanzwicklung sowie eine Kühleinrichtung, die zur Kühlung des Supraleiters mit dem erfindungsgemäßen Verfahren ausgebildet ist. Weiterhin betrifft die Erfindung eine supraleitende Maschine gemäss Anspruch 9, umfassend eine in einem Rotor an einem Wicklungsträger angeordnete supraleitende Rotorwicklung sowie eine Kühleinrichtung, die zu Kühlung des Supraleiters mit dem erfindungsgemäßen Verfahren ausgebildet ist. Dabei lassen sich sämtliche Ausführungen bezüglich des Verfahrens zur Kühlung analog auf die Magnetresonanzeinrichtung und die supraleitende Maschine übertragen, so dass offensichtlich auch hier die durch die Erfindung erreichten Vorteile realisiert werden.

In dem erfindungsgemäßen Verfahren ist vorgesehen sein, dass durch eine Heizung definiert Blasen gasförmigen Kühlmediums in dem flüssigen Kühlmedium erzeugt werden, die das flüssige Kühlmedium in einer insbesondere vertikal verlaufenden Förderleitung transportieren. Dabei kann mit besonderem Vorteil auch ein der Heizung vorgeschaltetes Rückschlagventil eingesetzt werden. Denkbar ist es beispielsweise, dass die Heizung, welche als ein elektrisches Heizmittel ausgestaltet sein kann, zyklisch betrieben wird, um in un-/ regelmäßigen Abständen die Förderleitung einnehmende Blasen eines bestimmten Auftriebs zu erzeugen, welche dann flüssiges Kühlmedium durch die Förderleitung nach oben transportieren.

In einer Erfindungsalternative kann vorgesehen sein, dass bei einer in einem Bad befindlichen, den Supraleiter umfassenden supraleitenden Wicklung Kühlmedium durch die Blasenpumpe zu einem freiliegenden Teil der Wicklung gefördert wird. Ist der Supraleiter also in einem Bad aus flüssigem Kühlmedium angeordnet, ragen jedoch Teile der Wicklung aus dem flüssigen Kühlmedium heraus, so kann mittels der Blasenpumpe das flüssige Kühlmedium zu einem freiliegenden Teil der Wicklung gefördert werden, beispielsweise mittels der bereits bezüglich der Kühleinrichtung beschriebenen Fördereinrichtung. Dabei ist es möglich, insbesondere dann, wenn lediglich periodisch Kühlmedium nachgefüllt wird, den Betrieb der Blasenpumpe bzw. des Heizmittels davon abhängig zu machen, ob ein vorbestimmter Teil der Wicklung freiliegt, wobei beispielsweise eine zeitliche Ansteuerung über eine Steuereinrichtung erfolgen kann oder der Füllstand des Bades gemessen werden kann, wobei ab einem bestimmten Schwellwert die Blasenpumpe durch eine Steuereinrichtung aktiviert wird.

In einer weiteren Alternative des erfindungsgemäßen Verfahrens kann vorgesehen sein, dass bei einer an einem Wicklungsträger in einem Rotor einer supraleitenden Maschine angeordneten, den Supraleiter umfassenden supraleitenden Rotorwicklung das Kühlmedium durch die Blasenpumpe gegen die Schwerkraft zu einem Innenraum des Rotors, der als Verdampfungsraum wirkt, gefördert wird.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: eine supraleitende Maschine mit einer erfindungsgemäßen Kühleinrichtung, und
- Fig. 2: eine erfindungsgemäße Kühleinrichtung zur Kühlung einer Magnetresonanz-Wicklung.

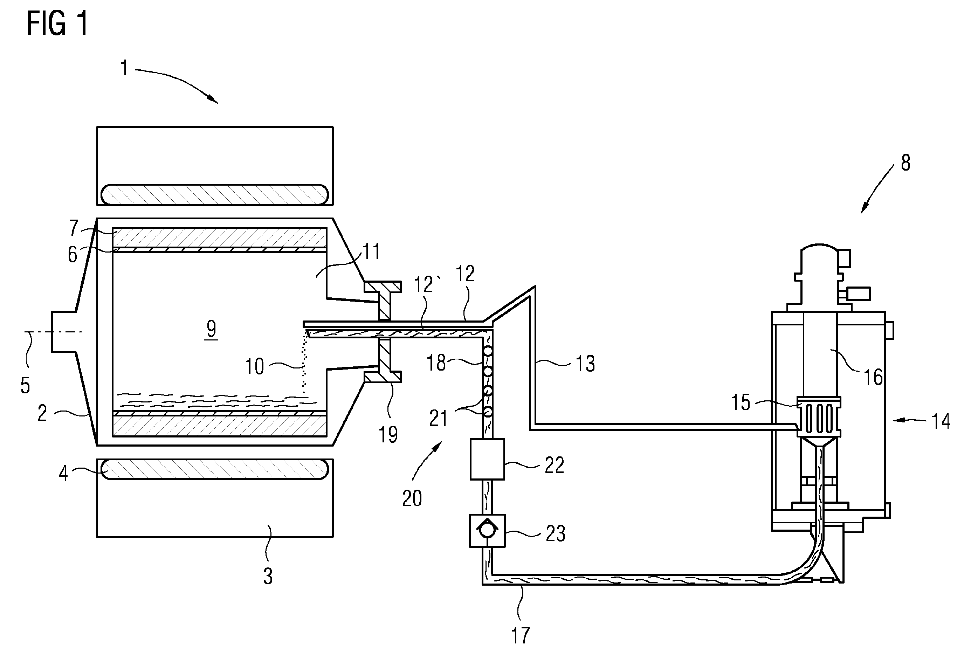

Fig. 1 zeigt eine erfindungsgemäße supraleitende Synchronmaschine 1. Sie umfasst einen Rotor 2, der auf grundsätzlich bekannte Weise innerhalb eines Stators 3 mit Statorwicklungen 4 rotierbar ist. Der Rotor 2, der um eine Drehachse 5 rotierbar ist, umfasst eine an einem thermisch leitfähigen Wicklungsträger 6 angeordnete supraleitende Wicklung 7, die aus einem Hochtemperatur-Supraleiter gefertigt ist.

Um die supraleitende Rotorwicklung 7 auf ihrer Betriebstemperatur zu halten, ist ferner eine erfindungsgemäße Kühleinrichtung 8 vorgesehen, die in diesem Fall ein Kühlmedium in einem geschlossenen Kühlkreislauf führt. Als Kühlmedium kann beispielsweise Neon oder Stickstoff verwendet werden. Ein hohler Innenraum 9 des Rotors 2 dient dabei als Verdampfungsraum, in den flüssiges Kühlmedium 10 eingebracht wird. In dem Verdampfungsraum 9 verdampft das flüssige Kühlmedium 10 zu gasförmigen Kühlmedium 11 und wird über ein Leitungsstück 12, durch das das gasförmige Kühlmedium 11 aus dem Innenraum 9 abgeführt wird und das parallel zu einem Leitungsstück 12', durch das das flüssige Kühlmedium 10 in den Innenraum 9 geführt wird, angeordnet ist, sowie einen weiteren Leitungsabschnitt 13 zu einem Kondensor 14 geführt, an dessen Kondensorraum 15 ein Kaltkopf 16 thermisch angekoppelt ist. Der Kaltkopf 16 kann beispielsweise über einen Kompressor betrieben werden.

Im Kondensorraum 15 kondensiert das gasförmige Kühlmedium 11 wiederum zu flüssigem Kühlmedium 10, welches über einen Leitungsabschnitt 17 und eine Förderleitung 18 wieder zu dem Leitungsstück 12 und von dort in den Innenraum 9 zurückgeführt wird. Dabei ist bis auf den Innenraum 9 die Kühleinrichtung 8 feststehend; die Ankopplung des Leitungsstücks 12 an den Innenraum 9 erfolgt wie im Stand der Technik bekannt durch eine Drehdurchführung 19.

In der supraleitenden Synchronmaschine 1, welche als Generator oder als Motor betrieben werden kann, erfolgt der Transport des flüssigen Kühlmediums 10 nicht anhand der Schwerkraft, sondern über eine allgemein bei 20 gezeigte Blasenpumpe. Die Förderleitung 18 ist dabei vertikal ausgerichtet, um so den maximalen Auftrieb von Blasen 21 (Arbeitsgasblasen) aus gasförmigen Kühlmedium 11 zu nutzen. Die Blasen 21 transportieren flüssiges Kühlmedium 10 gegen die Schwerkraft zu dem Leitungsstück 12.

Erzeugt werden die Blasen 21 durch eine Heizung 22, hier ein elektrisches Heizmittel, das an die Förderleitung 18 angekoppelt ist und durch definierten Wärmeeintrag in das flüssige Kühlmedium 10 zum Transport des flüssigen Kühlmediums 10 geeignete Blasen 21 erzeugt. Beispielsweise kann hier ein zyklischer Betrieb der Heizung 22 vorgesehen werden.

Der Heizung 22 vorgeschaltet ist ein Rückschlagventil 23, welches die Gesamteffizienz der Förderung durch die Blasen 21 erhöht.

Auf diese Weise ist es aufwandsarm und einfach realisierbar möglich, das flüssige Kühlmedium 10 auch gegen die Schwerkraft zu befördern, so dass der Kondensorraum 15 problemlos niedriger als der Innenraum 9 angeordnet werden kann.

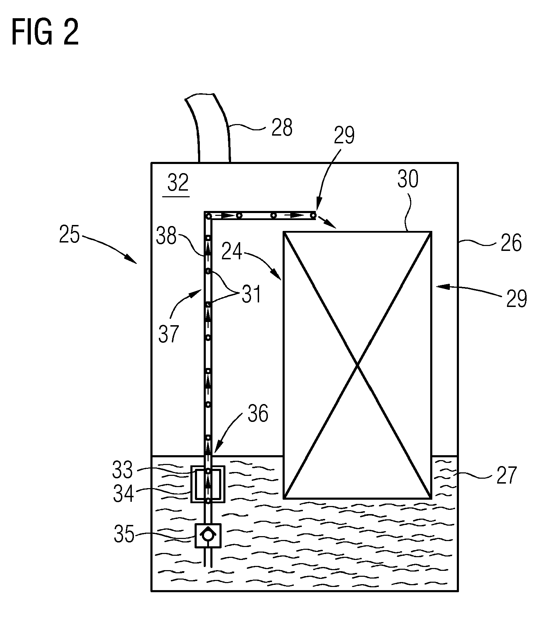

Eine Blasenpumpe kann erfindungsgemäß auch besonders vorteilhaft in einer Magnetresonanzeinrichtung eingesetzt werden, wie Fig. 2 näher erläutert. Gezeigt ist der Einfachheit halber nicht die gesamte Magnetresonanzeinrichtung, sondern lediglich die supraleitende Magnetresonanz-Wicklung 24, welche aus einem Niedrigtemperatur-Supraleiter gefertigt ist, sowie das dort eingesetzte Ausführungsbeispiel einer erfindungsgemäßen Kühleinrichtung 25. Ersichtlich ist die Wicklung 24 in einem Verdampfungsraum 26 angeordnet, der üblicherweise in einem Vakuumgefäß zu finden ist. Zur Kühlung wird ein flüssiges Kühlmedium 27, hier Helium, verwendet, welches an der Wicklung 24 verdampft und somit seine Kühlwirkung entfaltet. In bestimmten Zeitabschnitten, beispielsweise periodisch oder abhängig von den Messwerten eines hier nicht näher gezeigten Füllstandsensors, wird durch eine Zuleitung 28 flüssiges Kühlmedium 27 nachgefüllt.

Zu diesem Zeitpunkt, also unmittelbar nach dem Nachfüllen, kann auch vorgesehen sein, dass die Wicklung 24 vollständig von dem flüssigen Kühlmedium 27 umschlossen ist. Mit der Zeit sinkt der Pegel des flüssigen Kühlmediums 27 jedoch, so dass die Wicklung 24 nur noch teilweise durch es umschlossen ist. Dann kann es am oberen, freiliegenden Teil 29 der Wicklung 24 zu höheren Temperaturen kommen.

Um dem entgegenzuwirken, umfasst die Kühleinrichtung 25 eine Fördereinrichtung 37, die wiederum mit einer Blasenpumpe 36 ausgestattet ist. Dazu ist eine Förderleitung 38 vorgesehen, über die flüssiges Kühlmedium 27 durch eine Öffnung 29 auf eine obere Oberfläche 30 der Wicklung 24 gefördert werden kann. Zur Förderung werden auch hier wieder Blasen 31 aus gasförmigen Kühlmedium 32 verwendet, die durch eine wiederum als elektrisches Heizmittel ausgebildete Heizung 33 erzeugt werden. Die Heizung 33 ist so positioniert, dass sie sich grundsätzlich innerhalb des flüssigen Kühlmediums 27 befindet, weshalb sie auch von einer Isoliervorrichtung 34 in Form einer thermischen Isolierung, beispielsweise einem Vakuumraum, umgeben ist. Dabei wird die Heizung 33 wiederum so betrieben, dass sie zum Transport des flüssigen Kühlmediums 27 durch die vertikale Förderleitung 38 geeignete Blasen 31 erzeugt. Hierzu kann beispielsweise ein zyklischer Betrieb des Heizmittels 33 vorgesehen werden.

Es sei an dieser Stelle angemerkt, dass die Fördereinrichtung 37 nicht ständig in Betrieb sein muss, sondern vorgesehen sein kann, dass diese nur dann aktiviert wird, wenn der Pegelstand des flüssigen Kühlmediums 27 unter einen bestimmten Wert fällt und/oder eine vorbestimmte Zeit seit dem letzten Nachfüllen von flüssigem Kühlmedium 27 vergangen ist. Hierzu kann eine Steuereinrichtung (nicht gezeigt) vorgesehen werden, die die Heizung 33 entsprechend ansteuert.

Ferner ist auch im gezeigten Ausführungsbeispiel wiederum zur Verbesserung der Effizienz der Förderung des flüssigen Kühlmediums 27 ein der Heizung 33 in Förderrichtung vorgeschaltetes Rückschlagventil 35 vorgesehen.

Mithin erlaubt die erfindungsgemäß vorgeschlagene Verwendung einer Blasenpumpe 20, 36 auch auf aufwandsarme Weise ohne Verwendung einer das Kühlmedium 27 mechanisch fördernden Umwälzpumpe ein Umwälzen des flüssigen Kühlmediums 27 und somit eine gleichmäßigere Kühlung der Wicklung 24.

## Patentansprüche

1. Verfahren zur Kühlung eines Supraleiters, wobei der Supraleiter und/oder ein den Supraleiter tragendes Bauteil in Kontakt mit einem flüssigen Kühlmedium (10, 27) gebracht wird, **dadurch gekennzeichnet, dass** das Kühlmedium (10, 27) mit einer in einer Förderleitung (18, 38) angeordneten Blasenpumpe (20, 36) zu dem Supraleiter gefördert wird und/oder das Kühlmedium (10, 27) in einem Bad für den Supraleiter mit der in der Förderleitung (18, 38) angeordneten Blasenpumpe (20, 36)umgewälzt wird, wobei in beiden Fällen mit einer an die Förderleitung (18, 38) angekoppelten Heizung (22, 33) definiert Blasen (21, 31) gasförmigen Kühlmediums (11, 32) in der Förderleitung (18, 38) erzeugt werden, die das verflüssigte Kühlmedium in der Förderleitung gegen die Schwerkraft fördern.

2. Verfahren nach Anspruch 1, **dadurch gekennzeichnet, dass** die Förderleitung (18, 38) wenigstens im Bereich der Förderung durch die Blasenpumpe (20, 36) vertikal verläuft.

3. Verfahren nach einem der vorangehenden Ansprüche, **dadurch gekennzeichnet, dass** der Blasenpumpe (20, 36) in Förderrichtung ein Rückschlagventil (23, 35) vorgeschaltet ist.

4. Verfahren nach einem der vorangehenden Ansprüche, **dadurch gekennzeichnet, dass** der zu kühlende Supraleiter ein Supraleiter einer supraleitenden Magnetresonanz-Wicklung (24) ist und, dass die Blasenpumpe (36) ein nicht die gesamte Wicklung (24) in einem Verdampfungsraum (26) aufnehmendes flüssiges Kühlmediums (27) zu dem freiliegenden Teil der Wicklung (24) fördert, insbesondere auf eine obere Oberfläche (30) der Wicklung (24).

5. Verfahren nach einem der Ansprüche 1 bis 3, **dadurch gekennzeichnet, dass** der zu kühlende Supraleiter ein Supraleiter einer in einem Rotor (2) einer supraleitenden Maschine (1) angeordneten supraleitenden Rotorwicklung (7) ist, wobei das Kühlmedium (10) von einem insbesondere geodätisch niedriger liegenden Kondensorraum (15) durch die Förderleitung (18) in einen als Verdampfungsraum wirkenden Innenraum (9) des Rotors (2) gefördert wird.

6. Verfahren nach Anspruch 5, **dadurch gekennzeichnet, dass** das Kühlmedium (10) in einem geschlossenen Kühlkreislauf geführt wird, wobei das Kühlmedium (10) in dem an einen Kaltkopf (16) angekoppelten Kondensorraum (15) verflüssigt wird, dann zu dem zu kühlenden Supraleiter in den Innenraum (9) des Rotors (2) gefördert wird und anschließend gasförmig zurück zu dem Kondensorraum (15) geführt wird.

7. Verfahren nach Anspruch 5 oder 6, **dadurch gekennzeichnet, dass** die Förderleitung (18) in ein einen größeren Querschnitt aufweisendes, durch eine Drehdurchführung (19) in den Innenraum (9) des Rotors (2) mündendes Leitungsstück (12), mündet, in dem verflüssigtes Kühlmedium (10) in den Innenraum (9) des Rotors (2) strömt, wobei parallel durch ein weiteres Leitungsstück gasförmiges Kühlmedium (11) aus dem Innenraum (9) des Rotors (2) strömt.

8. Magnetresonanzeinrichtung, umfassend eine supraleitende Magnetresonanz-Wicklung (24) sowie eine Kühleinrichtung (25), welche die in Anspruch 1 definierte Blasenpumpe (20, 36), die Förderleitung (18, 38)und die Heizung (22, 33)umfasst, und welche derart zueinander angeordnet sind, dass die Kühleinrichtung (25) zur Kühlung eines Supraleiters der Magnetresonanz-Wicklung (24) mit einem Verfahren nach einem der Ansprüche 1 bis 4 ausgebildet ist, wobei zur Durchführung des Verfahrens aus Anspruch 3 der Blasenpumpe ein Rückschlagventil (23, 35) vorgeschaltet ist.

9. Supraleitende Maschine (1), umfassend eine in einem Rotor (2) an einem Wicklungsträger (6) angeordnete supraleitende Rotorwicklung (7) sowie eine Kühleinrichtung (8), welche die in Anspruch 1 definierte Blasenpumpe (20, 36), die Förderleitung (18, 38) und die Heizung (22, 33) umfasst, und welche derart zueinander angeordnet sind, dass die Kühleinrichtung (25) zur Kühlung der supraleitenden Rotorwicklung (7) mit einem Verfahren nach einem der Ansprüche 1 bis 3 oder 5 bis 7 ausgebildet ist, wobei zur Durchführung des Verfahrens aus Anspruch 3 der Blasenpumpe (20, 36) ein Rückschlagventil (23, 35) vorgeschaltet ist und zur Durchführung des Verfahrens der Ansprüche 6 bzw. 7 die Kühleinrichtung über die in diesen Ansprüchen definierten zusätzlichen Komponenten verfügt, nämlich den Kaltkopf (16), den Kondensorraum (15) bzw. im Falle des Verfahren aus Anspruch 7 die Drehdurchführung (19 und die Leitungsstücke (12, 19), welche derart zueinander angeordnet sind, dass die Kühleinrichtung zur Durchführung des Verfahrens aus Anspruch 6 bzw. 7 ausgebildet ist.

## Claims

1. Method for cooling a superconductor, whereby the superconductor and/or a component supporting the superconductor are brought into contact with a liquid coolant (10, 27), **characterised in that** the coolant (10, 27) is conveyed to the superconductor using a bubble pump (20, 36) disposed in a feed line (18, 38), and/or the coolant (10, 27) is circulated in a bath for the superconductor using the bubble pump (20, 36) disposed in the feed line (18, 38), wherein in both cases bubbles (21, 31) of gaseous coolant (11, 32) are produced in a defined manner in the feed line (18, 38) by means of a heater (22, 33) coupled to the feed line (18, 38), which bubbles (21, 31) convey the liquefied coolant in the feed line against gravity.

2. Method according to claim 1, **characterised in that** the feed line (18, 38) runs vertically at least in the region of delivery by means of the bubble pump (20, 36).

3. Method according to one of the preceding claims, **characterised in that** a non-return valve (23, 35) is installed upstream of the bubble pump (20, 36) in the delivery direction.

4. Method according to one of the preceding claims, **characterised in that** the superconductor that is to be cooled is a superconductor of a superconducting magnetic resonance winding (24) and **in that** the bubble pump (36) conveys a liquid coolant (27) not accommodating the entire winding (24) in an evaporation chamber (26) to the exposed part of the winding (24), in particular to an upper surface (30) of the winding (24).

5. Method according to one of claims 1 to 3, **characterised in that** the superconductor that is to be cooled is a superconductor of a superconducting rotor winding (7) disposed in a rotor (2) of a superconducting machine (1), wherein the coolant (10) can be conveyed from an in particular geodetically lower condenser chamber (15) through the feed line (18) into an interior space (9) of the rotor (2) acting as an evaporation chamber.

6. Method according to claim 5, **characterised in that** the coolant (10) is conveyed in a closed cooling circuit, wherein the coolant (10) is liquefied in a condenser chamber (15) coupled to a cold head (16), and is then conveyed to the superconductor that is to be cooled in the interior (9) of the rotor (2) and subsequently back to the condenser chamber (15) in gaseous form.

7. Method according to claim 5 or 6, **characterised in that** the feed line (18) opens into a line segment (12) of larger cross-section leading into the interior (9) of the rotor (2) through a rotary feedthrough (19), in which line segment liquefied coolant (10) flows into the interior (9) of the rotor (2), wherein gaseous coolant (11) flows in parallel out of the interior (9) of the rotor (2) through another line segment.

8. Magnetic resonance device, comprising a superconducting magnetic resonance winding (24) as well as a cooling device (25) which comprises the bubble pump (20, 36) defined in claim 1, the feed line (18, 38) and the heater (22, 33), and which are disposed such that the cooling device (25) is designed for cooling a superconductor of the magnetic resonance winding (24) using a method according to one of claims 1 to 4, wherein for the performance of the method from claim 3 a non-return valve (23, 35) is installed upstream of the bubble pump.

9. Superconducting machine (1), comprising a superconducting rotor winding (7) disposed on a winding support (6) in a rotor (2) as well as a cooling device (8) which comprises the bubble pump (20, 36) defined in claim 1, the feed line (18, 38) and the heater (22, 33), and which are disposed such that the cooling device (25) is designed for cooling the superconducting rotor winding (7) using a method according to one of claims 1 to 3 or 5 to 7, wherein for the performance of the method from claim 3 a non-return valve (23, 35) is installed upstream of the bubble pump (20, 36) and for the performance of the method according to claims 6 or 7 the cooling device possesses the additional components defined in said claims, namely the cold head (16), the condenser chamber (15) or in the case of the method from claim 7 the rotary feedthrough (19) and the line segments (12, 19), which are disposed such that the cooling device is designed for the performance of the method from claim 6 or 7.

## Revendications

1. Procédé de refroidissement d'un supraconducteur, dans lequel on met le supraconducteur et/ou une pièce portant le supraconducteur en contact avec un fluide ( 10, 27 ) de refroidissement liquide, **caractérisé en ce qu'**on véhicule le fluide ( 10, 27 ) de refroidissement au supraconducteur par une pompe ( 20, 36 ) à bulles montée dans un conduit ( 18, 38 ) d'acheminement et/ou on fait recirculer le fluide ( 10, 27 ) de refroidissement dans un bain pour le supraconducteur par la pompe ( 20, 36 ) à bulles montée dans le conduit ( 18, 38 ) d'acheminement, dans lequel, dans les deux cas, on produit, dans le conduit ( 18, 38 ) d'acheminement, par un chauffage ( 22, 33 ) adjoint au conduit ( 18, 38 ) d'acheminement, d'une manière définie, des bulles ( 21, 31 ) du fluide ( 11, 32 ) de refroidissement gazeux, qui véhiculent le fluide de refroidissement liquéfié dans le conduit d'acheminement à l'encontre de la force de la gravité.

2. Procédé suivant la revendication 1, **caractérisé en ce que** le conduit ( 18, 38 ) d'acheminement s'étend verticalement, au moins dans la zone de l'acheminement, par la pompe ( 20, 36 ) à bulles.

3. Procédé suivant l'une des revendications précédentes, **caractérisé en ce qu'**un clapet ( 23, 35 ) antiretour est monté en amont de la pompe ( 20, 36 ) à bulles dans le sens d'acheminement.

4. Procédé suivant l'une des revendications précédentes, **caractérisé en ce que** le supraconducteur à refroidir est un supraconducteur d'un enroulement ( 24 ) de résonance magnétique supraconducteur et **en ce que** la pompe ( 36 ) à bulles véhicule un fluide ( 27 ) de refroidissement liquide ne recevant pas tout l'enroulement ( 24 ) dans une chambre ( 26 ) d'évaporation à la partie libre de l'enroulement ( 24 ), notamment à une surface ( 30 ) supérieure de l'enroulement ( 24 ).

5. Procédé suivant l'une des revendications 1 à 3, **caractérisé en ce que** le supraconducteur à refroidir est un supraconducteur d'un enroulement ( 7 ) rotorique supraconducteur monté dans un rotor ( 2 ) d'une machine ( 1 ) supraconductrice, le fluide ( 10 ) de refroidissement étant véhiculé dans le conduit ( 18 ) d'acheminement d'une chambre ( 15 ) formant condenseur, notamment basse géodésiquement, à une chambre ( 9 ) intérieure agissant comme chambre d'évaporation du rotor ( 2 ).

6. Procédé suivant la revendication 5, **caractérisé en ce que** l'on fait passer le fluide ( 10 ) de refroidissement dans un circuit de refroidissement fermé, le fluide ( 10 ) de refroidissement étant liquéfié dans la chambre ( 35 ) de condenseur adjointe à une tête ( 7 ) froide, puis véhiculé au supraconducteur à refroidir dans la chambre ( 9 ) intérieure du rotor ( 2 ) et ensuite retourné sous forme gazeuse à la chambre ( 15 ) formant condenseur.

7. Procédé suivant la revendication 5 ou 6, **caractérisé en ce que** le conduit ( 18 ) d'acheminement débouche dans un tronçon ( 12 ) de conduit, qui a une section transversale plus grande, qui débouche par un passage ( 19 ) tournant dans la chambre ( 9 ) intérieure du rotor ( 2 ) et dans lequel du fluide
( 10 ) de refroidissement liquéfié s'écoule dans la chambre ( 9 ) intérieure du rotor ( 2 ), du fluide ( 11 ) de refroidissement gazeux sortant en parallèle par un autre tronçon de conduit de l'espace ( 9 ) intérieur du rotor ( 2 ).

8. Dispositif de résonance magnétique, comprenant un enroulement ( 24 ) supraconducteur de résonance magnétique, ainsi qu'un dispositif ( 25 ) de refroidissement, qui comprend la pompe ( 20, 36 ) à bulles, le conduit ( 18, 38 ) d'acheminement et le chauffage ( 22, 33 ) défini à la revendication 1, lesquels sont montés les uns par rapport aux autres, de manière à ce que le dispositif ( 25 ) de refroidissement soit constitué pour le refroidissement d'un supraconducteur de l'enroulement ( 24 ) de résonance magnétique par un procédé suivant l'une des revendications 1 à 4, un clapet ( 23, 35 ) antiretour étant monté en amont de la pompe à bulles pour effectuer le procédé suivant la revendication 3.

9. Machine ( 1 ) supraconductrice, comprenant un enroulement ( 7 ) supraconducteur rotorique monté sur un support ( 6 ) d'enroulement dans un rotor ( 2 ), ainsi qu'un dispositif ( 8 ) de refroidissement, qui comprend la pompe ( 20, 36 ) à bulles, le conduit ( 18, 38 ) d'acheminement et le chauffage ( 22, 32 ) définis à la revendication 1, lesquels sont montés les uns par rapport aux autres, de manière à ce que le dispositif ( 25 ) de refroidissement soit constitué pour le refroidissement de l'enroulement ( 7 ) supraconducteur rotorique par un procédé suivant l'une des revendications 1 à 3 ou 5 à 7, dans laquelle, pour effectuer le procédé suivant la revendication 3, un clapet ( 23, 35 ) antiretour est monté en amont de la pompe ( 20, 36 ) à bulles et, pour effectuer le procédé suivant la revendication 6 ou 7, le dispositif de refroidissement dispose des composants supplémentaires définis dans ces revendications, à savoir la tête ( 16 ) froide, la chambre ( 15 ) formant condenseur ou, dans le cas du procédé de la revendication 7, le passage ( 19 ) tournant et les tronçons ( 12, 19 ) de conduit, qui sont montés les uns par rapport aux autres, de manière à ce que le dispositif de refroidissement soit constitué pour effectuer le procédé suivant la revendication 6 ou 7.
